# EUROPEAN PATENT APPLICATION

(11) **EP 4 593 564 A1**
(43) Date of publication of application: **30.07.2025**
(21) Application number: 23868503.6
(22) Date of filing: 15.09.2023
(51) Int. Cl.: H10K 30/10, H10K 30/88, H10K 85/60, H10K 85/20

(54) **ELECTRON CARRIER FOR ELECTRON TRANSPORT LAYER OF PEROVSKITE SOLAR CELL, ELECTRON TRANSPORT LAYER COATING AGENT COMPRISING SAME, ELECTRON TRANSPORT LAYER, AND PEROVSKITE SOLAR CELL**

(30) Priority: 20.09.2022 KR 20220118424
(71) Applicant: Hanwha Solutions Corporation, Jung-gu Seoul 04541 (KR)
(72) Inventor: YEOM, Eun Joo, Seoul 04541 (KR)
(74) Representative: Mooser, Sebastian Thomas
(86) International application number: PCT/KR2023/013906
(87) International publication number: WO 2024/063450

(57) **Abstract**

The present invention relates to a coating agent for forming an electron transport layer (or electron transfer layer), wherein surface-modified metal oxide nanoparticles prepared in the form of a dispersion solution are provided as the coating agent, and relates to an inverted perovskite in which an electron transport layer is formed using the same.

## Description

### TECHNICAL FIELD

The present invention relates to a coating agent for forming an electron transport layer (ETL) of a perovskite solar cell, an electron carrier used therefor, an electron transport layer formed with the coating agent, and a perovskite solar cell including the same.

This application claims priority to and the benefit of Korean Patent Application No. 10-2022-0118424, filed on September 20, 2022, the disclosure of which is incorporated herein by reference in its entirety.

### BACKGROUND ART

In order to solve global environmental problems caused by the depletion of fossil energy and its use, research is being actively conducted on renewable and clean alternative energy sources such as solar energy, wind power and hydropower.

Among these, interest in solar cells, which change electrical energy directly from sunlight, is greatly increasing. Herein, a solar cell refers to a cell that generates current-voltage by absorbing light energy from sunlight and using the photovoltaic effect to generate electrons and holes.

Currently, n-p diode-type silicon (Si) single crystal-based solar cells with a light energy conversion efficiency of over 20% can be manufactured and are used in actual solar power generation, and there are also solar cells using compound semiconductors such as gallium arsenide (GaAs) that have even higher conversion efficiencies. However, these inorganic semiconductor-based solar cells require highly purified materials to achieve high efficiency, and thus, a lot of energy is consumed in purifying the raw materials, and expensive process equipment is required in the process of turning the raw materials into single crystals or thin films. Therefore, there are limitations to lowering the manufacturing cost of solar cells, and it has been an obstacle to their large-scale use.

Accordingly, in order to manufacture solar cells at low cost, it is necessary to significantly reduce the cost of the materials or manufacturing process used as the core of solar cells, and research is being conducted on perovskite solar cells that can be manufactured by using low-cost materials and processes as an alternative to inorganic semiconductor-based solar cells.

Recently, a perovskite solar cell using (NH₃CH₃)PbX₃ (X=I, Br, Cl), which is a halogen compound with a perovskite structure, as a photoactivator has been developed, and research for commercialization is underway. The general structural formula of the perovskite structure is the ABX₃ structure, where an anion is located at the X site, a large cation is located at the A site, and a small cation is located at the B site.

Perovskite solar cells, which are organometallic halide compounds with the molecular formula (CH₃NH₃)PbX₃, were first used as photoactive materials in solar cells in 2009. Since the development of a solid-type perovskite solar cell with the current structure in 2012, rapid improvements in efficiency have been achieved. A typical perovskite solar cell uses metal oxide as an electron transport layer and mainly uses organic or polymer materials such as spiro-OMETAD as a hole transport layer (HTL). That is, a metal oxide porous film or thin film is produced on a transparent electrode such as FTO, and a perovskite material is coated. Afterwards, a hole transport layer is coated, and an electrode layer such as gold (Au) or silver (Ag) is deposited.

An important task for commercialization of perovskite solar cells is securing stability and flexible technology. The existing electron transport layer formed by using a metal oxide on top of the photoactive layer was formed by depositing or coating a metal oxide on top of the photoactive layer (or light absorption layer), and then forming a separate organic binder coating layer on top of it. However, when forming a metal oxide by depositing, the manufacturing process is complex and multi-step, thereby greatly increasing the manufacturing cost, and there is a disadvantage in that the light absorption layer may be damaged by physical and chemical energy generated during the deposition process. In addition, the method of forming an organic binder coating layer involves high-temperature heat treatment to form a coating layer, but perovskite materials have the problem of decomposing at high temperatures above 200°C and deteriorate the flexibility of the solar cell, making the perovskite solar cell difficult to use, and thus, there is a problem of narrowing the scope of application of perovskite solar cells. When a dispersant is used to form a thin film with a uniform electron transport layer, a high temperature (over 500°C) heat treatment process is required to remove the dispersant, and thus, this also has the problem of damaging a perovskite layer.

In addition, when a passivation layer of fullerene-based material is formed between a perovskite light absorption layer and an electron transport layer, damage to the light absorption layer can be prevented to some extent, but depending on the electron transport layer material, there is a problem in that the electron carrier reacts with the fullerene in the passivation layer, thereby damaging the passivation layer and lowering the performance of a solar cell device.

### DISCLOSURE

### TECHNICAL PROBLEM

The present invention has been devised to overcome the above-described problems, and is directed to providing an electron transport layer (or an electron transporting layer, ETL) and a coating agent for forming an electron transport layer using the same, wherein metal oxide nanoparticles that are surface-modified with a specific material are applied as an electron carrier, and a coating agent and an electron transport layer manufactured in a dispersion type thereof are formed, thereby providing a perovskite solar cell with excellent performance.

### TECHNICAL SOLUTION

In order to solve the above-described problems, the present invention is an invention that relates to an electron carrier for an electron transport layer of a perovskite solar cell, including metal oxide nanoparticles that are surface-modified with a phosphonium salt represented by Chemical Formula 1 below:

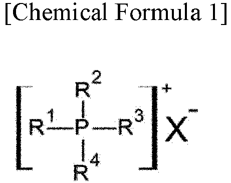

wherein in Chemical Formula 1, each of R¹ to R⁴ is independently a C₁ to C₁₀ straight-chain alkyl group, a C₃ to C₁₀ branched alkyl group, a phenyl group or a benzyl group, and X is a halogen atom or -OH.

In a preferred embodiment of the present invention, the metal oxide nanoparticles may include an oxide of a metal including at least one or two selected from tin (Sn), zirconium (Zr), strontium (Sr), zinc (Zn), vanadium (V), molybdenum (Mo), tungsten (W), niobium (Nb), aluminum (Al) and gallium (Ga).

In a preferred embodiment of the present invention, the metal oxide nanoparticles may include at least one selected from SnO₂. ZnO, TiO₂, CeO₂, ZrO₂, WO₃, Zn₂SnO₄, BaSnO₃ and SrTiO₃.

In a preferred embodiment of the present invention, the metal oxide nanoparticles may be constituted to have a particle size of 2 to 100 nm.

In a preferred embodiment of the present invention, the electron carrier may include 85.0 to 95.0 wt% of the metal oxide nanoparticles and the remaining amount of a surface modification component based on the total weight of the electron carrier.

Another object of the present invention relates to a coating agent for an electron transport layer of a perovskite solar cell, and it is a dispersion in which the above-described electron carrier is dispersed, and it includes an organic solvent and the electron carrier that is dispersed in the organic solvent.

In a preferred embodiment of the present invention, the coating agent for an electron transport layer of a solar cell of the present invention may include 0.30 to 2.00 wt% of an electron carrier and the remainder of an organic solvent.

In a preferred embodiment of the present invention, the organic solvent may have a dielectric constant of 20 or less.

In a preferred embodiment of the present invention, the organic solvent may include at least one selected from isopropyl alcohol, butyl alcohol, 2,2,2-trifluoroethanol, chlorobenzene and chloroform.

In addition, another object of the present invention relates to an electron transport layer of a perovskite solar cell, including a coating layer formed by the above-described coating agent.

In a preferred embodiment of the present invention, the electron transport layer may have a thickness of 10 to 100 nm, and

In a preferred embodiment of the present invention, when the electron transport layer has a thickness of 10 to 15 nm, the electron transport layer may have a light transmittance of 88.0% or more for a wavelength of 500 to 550 nm.

In addition, another object of the present invention relates to a perovskite solar cell including the electron transport layer, and the electron transport layer may be directly formed on an upper surface of a perovskite light absorption layer, or a passivation layer may be formed between a perovskite light absorption layer and the electron transport layer of claim 8.

### ADVANTAGEOUS EFFECTS

The coating agent for forming an electron transport layer of the present invention can form an ultra-thin film through low-temperature heat treatment below 200°C without a high-temperature treatment process for forming a thin film, thereby preventing damage to a perovskite light absorption layer. In addition, since there is no chemical reaction between the surface modification component of an electron carrier in the coating agent and the fullerene material of a passivation layer, damage to the passivation layer can be prevented. In addition, since the electron transport layer formed with the coating solution of the present invention has high thin film uniformity, it has excellent an open-circuit voltage (V_{oc}) and fill factor (FF) of solar cells, and has a high light transmittance with an excellent short-circuit current (J_{sc}), and thus, it is possible to provide a solar cell with excellent photo-electric conversion efficiency.

### DESCRIPTION OF DRAWINGS

FIG. 1 is a TEM measurement image of SnO₂ nanoparticles produced in Example 1.
FIG. 2 is an XRD measurement graph of SnO₂ nanoparticles produced in Example 1.
FIG. 3 is a FT-IR measurement graph of unmodified SnO₂ nanoparticles (control SnO₂) and surface-modified SnO₂ nanoparticles produced in Example 1.
FIG. 4 is a TGA measurement graph of unmodified SnO₂ nanoparticles (control SnO₂) and surface-modified SnO₂ nanoparticles produced in Example 1.
FIG. 4 (a) is a photograph taken of a solution in which unmodified SnO₂ nanoparticles were dispersed in isopropane alcohol, and (b) is a photograph taken of the coating solution for forming an electron transport layer prepared in Example 1.
FIG. 5 is a dynamic light scattering particle size analysis measurement graph for each of Example 2-1 (TBPH), Comparative Example 2-2 (TBAH) and Comparative Example 2-3 (TMAH) conducted in Experimental Example 2.
FIG. 6 shows the results of measuring the current density of inverted perovskite solar cells manufactured in Manufacture Example 1 (TPBH), Comparative Manufacture Example 2 (TBAH) and Comparative Manufacture Example 3 (TMAH) conducted in Experimental Example 2.
FIG. 7 shows the results of measuring the current density of silicon/perovskite tandem solar cells manufactured in Manufacture Example 4 (TPBH), Comparative Manufacture Example 2 (TBAH) and Comparative Manufacture Example 3 (TMAH) conducted in Experimental Example 3.

### MODES OF THE INVENTION

Hereinafter, the present invention will be described in more detail.

The present invention relates to an electron carrier that is applied to an electron transport layer (or electron transporting layer, ETL) of an inverted perovskite solar cell, and a dispersiontype coating agent using the same.

The electron carrier of the present invention includes metal oxide nanoparticles that are surface-modified with a phosphonium salt represented by Chemical Formula 1 below.

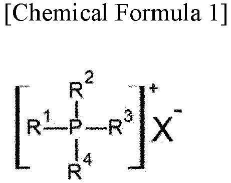

In Chemical Formula 1, each of R¹ to R⁴ is independently a C₁ to C₁₀ straight-chain alkyl group, a C₃ to C₁₀ branched alkyl group, a phenyl group or a benzyl group, preferably, a C₁ to C₁₀ straight-chain alkyl group, a phenyl group or a benzyl group, and more preferably a C₃-C₅ straight-chain alkyl group, a phenyl group or a benzyl group.

Additionally, in Chemical Formula 1, X is a halogen atom or -OH, and is preferably - Cl, -Br, -I or -OH.

The electron carrier of the present invention is surface-modified with the phosphonium salt to easily form a bond with the metal oxide nanoparticles due to the high reactivity of the phosphonium cation, and it is uniformly dispersed in an organic solvent due to the repulsion and steric effect between the substituents, and may form a uniform ultra-thin film (10 to 100 nm) when coated, and thus, it is easy to apply as an electron transport layer for a solar cell.

Among the constitutions of the electron carrier, the metal oxide nanoparticles include an oxide of a metal including at least one or two selected from tin (Sn), zirconium (Zr), strontium (Sr), zinc (Zn), vanadium (V), molybdenum (Mo), tungsten (W), niobium (Nb), aluminum (Al) and gallium (Ga). For a preferred embodiment of the metal oxide nanoparticles, the metal oxide nanoparticles include at least one or two selected from SnO₂, ZnO, TiO₂, CeO₂, ZrO₂, WO₃, Zn₂SnO₄, BaSnO₃ and SrTiO₃, and more preferably, it may include at least one or two selected from SnO₂, ZnO, TiO₂, CeO₂ and ZrO₂.

In addition, the metal oxide nanoparticles may have a particle diameter of 2 to 100 nm, preferably, 2 to 50 nm, and more preferably, 2 to 20 nm. In this case, if the particle size of the metal oxide nanoparticles exceeds 100 nm, there may be a problem in forming a thin and uniform thin film, and if the particle size is less than 2 nm, there is a problem in that it is practically difficult to manufacture and purchase.

The electron carrier may be synthesized by the following method.

The electron carrier of the present invention may be manufactured by performing a process including step 1 of producing metal oxide nanoparticles; and step 2 of producing surface-modified metal oxide nanoparticles by reacting the metal oxide with the compound represented by Chemical Formula 1.

More specifically, it may be manufactured by performing a process including step 1 including step 1-1 of preparing a metal precursor solution by mixing a metal precursor and ultrapure water; step 1-2 of preparing a reaction solution by adding a basic aqueous solution to the metal precursor solution; and step 1-3 of performing hydrothermal synthesis of the reaction solution and obtaining metal oxide nanoparticles from the hydrothermal synthesis.

The metal precursor solution of step 1-1 may include a metal precursor and ultrapure water, and the concentration of the metal precursor in the metal precursor solution may be 0.2 to 2.0 M, and preferably, 0.3 to 1.5 M. In this case, if the metal precursor concentration in the metal precursor solution is less than 0.2 M, the yield of metal oxide nanoparticles may be too small, and if the metal precursor concentration in the metal precursor solution exceeds 2.0 M, the viscosity of the metal precursor aqueous solution increases, and there may be a problem in that the size of metal oxide nanoparticles is formed unevenly when manufactured under the same process conditions, making it difficult to obtain uniform nanoparticles.

In this case, the metal precursor is an organic metal compound including at least one metal selected from tin (Sn), zirconium (Zr), strontium (Sr), zinc (Zn), vanadium (V), molybdenum (Mo), tungsten (W), niobium (Nb), aluminum (Al) and gallium (Ga), and a preferred example may include a halide of the metal, and preferably, a chloride of the metal, as a metal precursor.

The basic aqueous solution of step 1-2 may include at least one selected from an aqueous KOH solution, an aqueous NaOH solution, an aqueous hydrazine solution and an aqueous NH₄OH solution. In addition, the amount of basic aqueous solution used is added to the metal precursor solution such that the pH of the reaction solution is 8.0 or higher, preferably, pH 8.0 to pH 10.0, and more preferably, pH 8.0 to 9.0. In this case, if the pH is less than 8, the amount of metal oxide nanoparticles obtained may be too small. In addition, if the pH is between 6.0 and 8.0 (less than pH 8), the metal precursor solution may be gelated, and there may be a problem with poor stirring, and if the pH is too high, there may be a problem with the particle size of the metal oxide particles becoming too large.

The hydrothermal synthesis of steps 1-3 may be performed by applying a general hydrothermal synthesis method used in the art, and the hydrothermal synthesis is preferably performed at 100 to 200°C, preferably, 110 to 190°C, and more preferably, 120 to 180°C, for 6 to 48 hours, preferably, 10 to 24 hours, and more preferably, 12 to 18 hours. In this case, if the hydrothermal synthesis temperature is less than 100°C, there may be a problem of low crystallinity of the metal oxide, and if it exceeds 200°C, there may be a problem of an increase in the size of the metal oxide particles. In addition, if the hydrothermal synthesis time is less than 6 hours, there may be a problem in that the yield of metal oxide nanoparticles becomes too low, and if it exceeds 48 hours, there may be a problem in that the size of the hydrothermal composite becomes too large, and thus, it is preferable that hydrothermal synthesis is performed within the above time.

The metal oxide nanoparticles obtained through hydrothermal synthesis may be washed repeatedly 3 to 5 times by using ultrapure water and ethanol.

The metal oxide nanoparticles obtained in this way may have a particle diameter of 2 to 100 nm, preferably, an average particle diameter of 2 to 50 nm, more preferably, an average particle diameter of 2 to 20 nm, and even more preferably, 2 to 10 nm.

In addition, the metal oxide nanoparticles are as described above.

Next, step 2 is a process of modifying the surface of the metal oxide nanoparticles obtained in step 1, and it may perform a process including step 2-1 of mixing the metal oxide nanoparticles, a C₃ to C₅ alcohol, and an aqueous solution containing the compound represented by Chemical Formula 1 to prepare a reaction solution; step 2-2 of performing a stirring reaction on the reaction solution; step 2-3 of separating a reaction product from the solution in which the stirring reaction has been performed and washing the separated reaction product; and step 2-4 of drying the washed reaction product to obtain surface-modified metal oxide nanoparticles.

In the constitutions of the reaction solution, the C₃ to C₅ alcohol plays a role in preventing the surface-modified SnO₂ particles from agglomerating, and preferably, 2-propanol may be used. In addition, the amount used may be 80 to 200 parts by weight, and preferably, 100 to 180 parts by weight, based on 100 parts by weight of metal oxide nanoparticles. In this case, if the amount of C₃ to C₅ alcohol used is less than 80 parts by weight, the surface modification reaction may not proceed well, and if it is used in excess of 200 parts by weight, there may be difficulty in obtaining modified nanoparticles.

The reaction solution may include 100 to 220 parts by weight of an aqueous solution containing the compound represented by Chemical Formula 1, preferably, 120 to 200 parts by weight, and more preferably, 130 to 180 parts by weight, based on 100 parts by weight of metal oxide nanoparticles. In this case, if the amount of the aqueous solution containing the compound represented by Chemical Formula 1 is less than 100 parts by weight, there may be a problem in that the surface modification is not performed evenly due to insufficient stirring of the solvent during the surface modification process, and if it exceeds 220 parts by weight, there may be a problem in that the stirring reaction time becomes too long.

In addition, the content of the compound represented by Chemical Formula 1 in the aqueous solution containing the compound represented by Chemical Formula 1 is 10 to 80 wt%, preferably, 30 to 80 wt%, and more preferably, 30 to 70 wt%. In this case, if the content of the compound represented by Chemical Formula 1 is less than 10 wt%, the degree of modification of the metal oxide surface may be too insufficient or uneven, and thus, there may be a problem in that the metal oxide particles are not evenly dispersed in the solvent and precipitated. If it exceeds 80.0 wt%, it is not economically feasible, and there may be a problem in that the purity of the electron carrier decreases due to unreacted compounds, and thus, it is preferable that it is used within the above range.

The stirring reaction may be performed under room temperature conditions for 5 minutes to 2 hours, and preferably, for 10 minutes to 1 hour. In this case, if the stirring reaction time is less than 5 minutes, there may be a problem of insufficient stirring, and if it exceeds 2 hours, it has the disadvantage of not being economically feasible.

Separation and/or washing in steps 2-4 may be performed by common methods used in the art. For an embodiment, it may be performed by performing centrifugation to obtain a stirred reaction product from the reaction solution and then washing the same with ultrapure water and the like.

Drying in step 2-5 may be performed by common methods used in the art. For an embodiment, it may be performed by heating the reaction product obtained by washing in an oven at 50 to 80°C.

The electron carrier of the present invention may include 85 to 95 wt% of the metal oxide nanoparticles and the remaining amount of surface modification components, preferably, 88 to 94 wt% of the metal oxide nanoparticles and the remaining amount of surface modification components, and, more preferably, 90.0 to 94.0 wt% of the metal oxide nanoparticles and the remaining amount of surface modification components based on the total weight.

The coating agent for an electron transport layer (ETL) of a perovskite solar cell of the present invention uses the electron carrier described above, and includes an organic solvent and the electron carrier dispersed in the organic solvent.

In addition, the organic solvent may have a dielectric constant of 20 or less, and preferably, a solvent having a dielectric constant of 5 to 15 may be used. Specific examples of such organic solvents may include at least one selected from isopropyl alcohol, butyl alcohol, 2,2,2-trifluoroethanol, chlorobenzene and chloroform. Preferably, at least one selected from isopropyl alcohol, 2,2,2-trifluoroethanol and chlorobenzene may be used alone or in combination.

If an organic solvent with a dielectric constant exceeding 20 is used, there may be a problem in that the perovskite material, which is a light absorption layer, is decomposed by the organic solvent during the process of forming a thin electron transport layer.

The coating agent for ETL of the present invention includes 0.30 to 2.00 wt% of the electron carrier and the remaining amount of an organic solvent, preferably, 0.30 to 1.50 wt% of the electron carrier and the remaining amount of the organic solvent, and more preferably, 0.35 to 1.00 wt% of the electron carrier and the remaining amount of the organic solvent based on the total weight.

In this case, if the content of the electron carrier in the coating is less than 0.30 wt%, the content of the electron carrier is not sufficient, and there may be a problem of exposure of the light absorption layer when forming the ETL thin film. If it exceeds 2.00 wt%, the ETL thickness increases, and since there may be a problem of decreasing the short-circuit current (J_{sc}) and open circuit voltage (V_{oc}) values of the solar cell, it is recommended to include an electron carrier within the above range.

The coating agent for forming an ETL of the present invention described above is coated by using general coating methods such as spin coating, blade coating, bar coating, spray coating, gravure coating, die coating and the like. For an embodiment, after coating, heat treatment may be performed at 200°C or less to form an ultra-thin film with a thickness of 10 to 100 nm or less, preferably, 10 to 70 nm thick, and more preferably, 10 to 50 nm.

Using the coating agent of the present invention, an inverted structure or PIN structure perovskite solar cell may be manufactured as follows.

The inverted perovskite solar cell of the present invention may be a solar cell in which a conductive substrate, a drain electrode, a hole transport layer (HTL), a light absorption layer (or photoactive layer), an electron transport layer (or electron transporting layer, ETL) and a source electrode are sequentially laminated.

Additionally, the perovskite solar cell may further include a passivation layer between the light absorption layer and the electron transport layer. In this case, the passivation layer may include at least one selected from C₆₀ fullerene, C₇₀ fullerene, C₇₂ fullerene, C₇₆ fullerene and C₈₄ fullerene.

In addition, the inverted perovskite solar cell of the present invention constitutes a set in which a conductive substrate, a drain electrode, a hole transport layer, a light absorption layer, an electron transport layer and a source electrode are sequentially laminated, and the set may be formed by laminating a single layer or multiple layers.

The conductive substrate may be a general conductive substrate used in the industry, and for example, a transparent plastic substrate made of materials such as polyethylene terephthalate, polyethylene naphthalate, polyethersulfone, aromatic polyester or polyimide, glass substrates, quartz substrates, silicon substrates and the like may be used.

The drain electrode may be manufactured by a material including at least one selected from conductive metals, alloys of conductive metals, metal oxides and conductive polymers. Preferred examples may include indium tin oxide (ITO), fluorine doped tin oxide (FTO), Sb₂O₃ doped tin oxide (ATO), gallium doped tin oxide (GTO), tin doped zinc oxide (ZTO), gallium doped ZTO (ZTO:Ga), indium gallium zinc oxide (IGZO), indium doped zinc oxide (IZO) and/or aluminum doped zinc oxide (AZO).

Additionally, the hole transport layer (HTL) may include an inorganic and/or organic hole transport material. The inorganic hole transport material may include at least one selected from nickel oxide (NiOₓ), CuSCN, CuCrO₂ and CuI.

The organic hole transport material may include carbazole derivatives, polyarylalkane derivatives, phenylenediamine derivatives, arylamine derivatives, amino-substituted chalcone derivatives, styrylanthracene derivatives, fluorene derivatives, hydrazone derivatives, stilbene derivatives, silazane derivatives, aromatic tertiary amine compounds, styrylamine compounds, aromatic dimethylidine compounds, porphyrin compounds, phthalocyanine compounds, polythiophene derivatives, polypyrrole derivatives, polyparaphenylenevinylene derivatives, pentacene, coumarin 6, 3-(2-benzothiazolyl)-7-(diethylamino)coumarin), zinc phthalocyanine (ZnPC), copper phthalocyanine (CuPC), titanium oxide phthalocyanine (TiOPC), Spiro-MeOTAD (2,2',7,7'-tetrakis(N,N-p-dimethoxyphenylamino)-9,9'-spirobifluorene), F16CuPC (copper(II) 1,2,3,4,8,9,10,11,15,16,17,18,22,23,24,25-hexadecafluoro-29H,31H-phthalocyanine), SubPc (boron subphthalocyanine chloride) and N3 (cis-di(thiocyanato)-bis(2,2'-bipyridyl-4,4'-dicarboxylic acid)-ruthenium(II), P3HT (poly[3-hexylthiophene]), MDMO-PPV (poly[2-methoxy-5-(3',7'-dimethyloctyloxyl)]-1,4-phenylene vinylene), MEH-PPV (poly[2-methoxy-5-(2"-ethylhexyloxy)-p-phenylene vinylene]), P3OT (poly(3-octyl thiophene)), POT (poly(octyl thiophene)), P3DT (poly(3-decyl thiophene)), P3DDT(poly(3-dodecyl thiophene), PPV (poly(p-phenylene vinylene)), TFB (poly(9,9'-dioctylfluorene-co-N-(4-butylphenyl)diphenyl amine), polyaniline, Spiro-MeOTAD ([2,22',7,77'-tetrkis (N,N-dipmethoxyphenyl amine)-9,9,9'-spirobi fluorine]), CuSCN, CuI, PCPDTBT (Poly[2,1,3-benzothiadiazole-4,7-diyl[4,4-bis(2-ethylhexyl-4H-cyclopenta [2,1-b:3,4-b']dithiophene-2,6-diyl]], Si-PCPDTBT (poly[(4,4'-bis(2-ethylhexyl)dithieno[3,2-b:2',3'-d]silole)-2,6-diyl-alt-(2,1,3-benzothiadiazole)-4,7-diyl]), PBDTTPD (poly((4,8-diethylhexyloxyl), PFDTBT (poly[2,7-(9-(2-ethylhexyl)-9-hexyl-fluorene)-alt-5,5-(4',7,-di-2-thienyl-2',1',3'-benzothiadiazole)]), PFO-DBT (poly[2,7-.9,9-(dioctyl-fluorene)-alt-5,5-(4',7'-di-2-.thienyl-2', 1', 3'-benzothiadiazole)]), PSiFDTBT (poly[(2,7-dioctylsilafluorene)-2,7-diyl-alt-(4,7-bis(2-thienyl)-2,1,3-benzothiadiazole)-5,5'-diyl]), PCDTBT (Poly [[9-(1-octylnonyl)-9H-carbazole-2,7-diyl] -2,5-thiophenediyl-2,1,3-benzothiadiazole-4,7-diyl-2,5-thiophenediyl]), PFB (poly(9,9'-dioctylfluorene-co-bis(N,N'-(4,butylphenyl))bis(N,N'-phenyl-1,4-phenylene)diamine), F8BT (poly(9,9'-dioctylfluorene-cobenzothiadiazole), PEDOT (poly(3,4-ethylenedioxythiophene)), PEDOT:PSS poly(3,4-ethylenedioxythiophene) poly(styrenesulfonate), PTAA (poly(triarylamine)), 2-PACz, Me-2PACz, 4-PACz, MeO-4PACz, Me-4PACz and/or MeO-2PACz.

In addition, methods for forming the hole transport layer may include coating and vacuum deposition methods, and coating methods may include gravure coating, bar coating, printing, spraying, spin coating, dip and die coating methods.

Additionally, in the constitutions of the solar cell of the present invention, the light absorption layer may include a perovskite material that is generally applied to the light absorption layer of a solar cell. For example, it may include a perovskite material represented by Chemical Formula 2 below.

[Chemical Formula 2] CMX₃

In Chemical Formula 2, C is a monovalent cation, which may include amines, ammonium, Group 1 metals, Group 2 metals and/or other cations or cation-like compounds, and preferably, it may be formamidinium (FA), methylammonium (MA), FAMA, CsFAMA or N(R)₄⁺ (where R may be the same or different group, and R is a linear alkyl group having 1 to 5 carbon atoms, a pulverized alkyl group having 3 to 5 carbon atoms, a phenyl group, an alkylphenyl group, an alkoxyphenyl group or an alkyl halide).

Additionally, M in Chemical Formula 2 is a divalent cation, and may include one or two selected from Fe, Co, Ni, Cu, Sn, Pb, Bi, Ge, Ti, Eu and Zr.

In addition, X in Chemical Formula 2 is a monovalent anion, and may include at least one halide element selected from F, Cl, Br and I and/or a Group 16 anion. As a preferred example, X may be IₓBr₃₋ₓ (0≤x≤3).

In addition, for a preferred embodiment of Chemical Formula 2, there are FAPbIₓBr₃₋ₓ (0≤x≤3), MAPbIₓBr₃₋ₓ (0≤x≤3), CsMAFAPbIₓBr₃₋ₓ (0≤x≤3), CH₃NH₃PbX₃ (X=Cl, Br, I, BrI₂, or Br₂I), CH₃NH₃SnX₃ (X=Cl, Br or I), CH(=NH)NH₃PbX₃ (X=Cl, Br, I, BrI₂, or Br₂I), CH(=NH)NH₃SnX₃ (X=Cl, Br or I) and the like.

Additionally, in the solar cell of the present invention, the light absorption layer may be a single layer composed of the same perovskite material, or may be a multilayer structure in which multiple layers composed of different perovskite materials are laminated, and the light absorption layer made of one type of perovskite material may include a heterogeneous perovskite material other than the one type of perovskite material having a pillar shape such as a columnar shape, a plate shape, a needle shape, a wire shape or a rod shape.

In the constitutions of the solar cell of the present invention, the electron transport layer may be formed on the light absorption layer by forming a thin film-type coating layer by coating a coating solution of the coating agent (dispersion of surface-modified metal oxide nanoparticles dispersed in an organic solvent, electron carrier) of the present invention as described above, and then performing a low-temperature heat treatment at 200°C or less, and preferably, 30 to 100°C or less.

In this case, the coating may be spin coating, blade coating, bar coating, spray coating, gravure coating or die coating.

In addition, it is desirable to form the electron transport layer to a thickness of 10 to 100 nm, preferably, 10 to 70 nm, and more preferably, 10 to 50 nm. In this case, if the thickness of the electron transport layer exceeds 200 nm, since there may be a problem of decreasing the short-circuit current (J_{sc}) and open circuit voltage (V_{oc}) of the solar cell, it is recommended to form it with a thickness within the above range.

The surface of the coating layer formed in this way, that is, the electron transport layer, may be formed to have very low roughness, and the RMS (root mean square) roughness may satisfy 50 nm or less, preferably, 5.00 to 30.00 nm, and more preferably, 10.00 to 25.00 nm.

Additionally, in the constitutions of the solar cell of the present invention, the source electrode may be formed by coating or depositing at least one material selected from Pt, Au, Ni, Cu, Ag, In, Ru, Pd, Rh, Ir, Os, C and conductive polymers.

The present invention may be applied to a heterojunction (tandem) perovskite solar cell. For example, a heterojunction perovskite solar cell may be a solar cell having a structure in which a conductive substrate, a drain electrode, a first light absorption layer (or a first photoactive layer), a recombination layer, a hole transport layer (HTL), a second light absorption layer (or a second photoactive layer), an electron transport layer (or an electron transporting layer, ETL) and a source electrode are sequentially laminated.

The first light absorption layer may be a silicon solar cell or a light absorption layer including the perovskite material described above.

If the first light absorption layer is a silicon solar cell, it may be a p-type silicon layer or an n-type silicon layer, and the doping layer may be n-type or p-type accordingly, and if it includes a perovskite material, a hole transport layer and an electron transport layer may be included between the drain electrode and the light absorption layer and between the light absorption layer and the recombination layer, respectively.

The conductive substrate, drain electrode, hole transport layer, second light absorption layer, electron transport layer and source electrode are the same as previously described for the inverted perovskite solar cell.

Additionally, the perovskite solar cell may further include a passivation layer between the second light absorption layer and the electron transport layer. In this case, the passivation layer may include at least selected from C₆₀ fullerene, C₇₀ fullerene, C₇₂ fullerene, C₇₆ fullerene and C₈₄ fullerene.

Hereinafter, the present invention will be described in more detail through examples. However, the following examples do not limit the scope of the present invention, and should be interpreted to aid understanding of the present invention.

### [Example]

### Example 1-1: Preparation of coating solution for forming electron transport layer (ETL)

### (1) Production of SnO₂ nanoparticles

SnCl₄5H₂O was added to a beaker containing ultrapure water and stirred to prepare a metal precursor solution with a SnCl₄ concentration of 0.5 M. Then, 85 mL of NH₄OH, which is a basic aqueous solution, was added to 215 mL of the metal precursor solution to prepare a reaction solution with a pH of about 8.0 to 8.5.

The reactive solution was placed in a pressure vessel (autoclave or hydrothermal reactor), and hydrothermal synthesis was performed at 120°C for 12 hours.

Next, the product obtained through hydrothermal synthesis was washed 3 to 5 times using ultrapure water and ethanol to produce SnO₂ nanoparticles.

The average particle diameter of the produced SnO₂ nanoparticles was 3 to 5 nm.

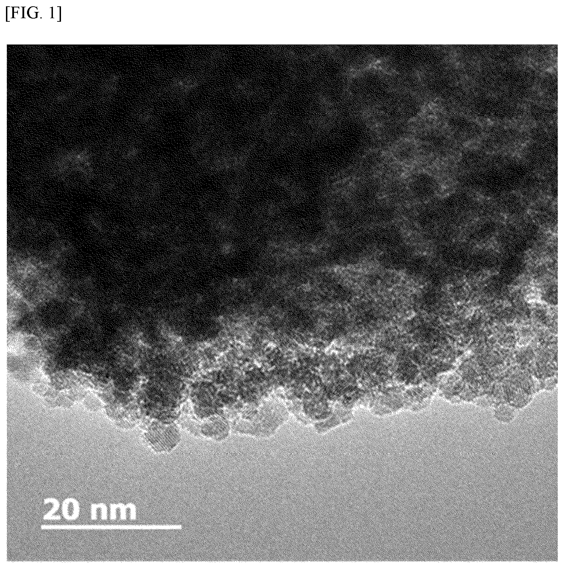

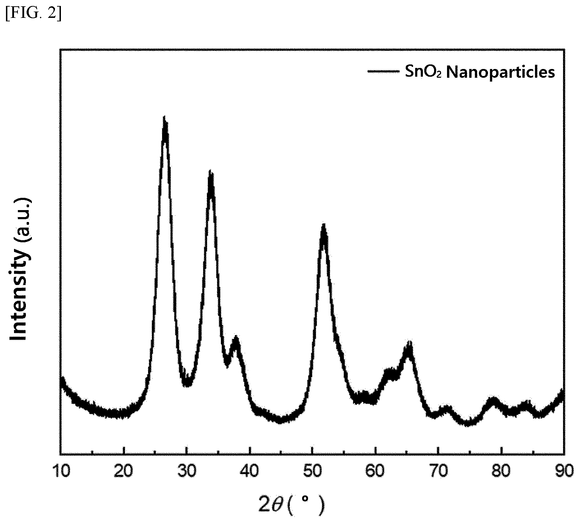

Additionally, the TEM measurement image of the produced SnO₂ nanoparticles is shown in FIG. 1, and the XRD measurement results are shown in FIG. 2.

### (2) Preparation of electron carrier (surface-modified SnO₂ nanoparticles)

5 g of the SnO₂ nanoparticles prepared above were added to a round bottom flask containing 7.5 mL of 2-propanol and stirred. and after adding 7.5 mL of an aqueous solution including 40 wt% of a compound (TBPH) represented by Chemical Formula 1-1, a reaction solution was prepared by using an ultrasonic grinder.

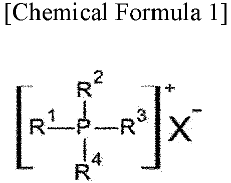

In Chemical Formula 1-1, each of R¹ to R⁴ is an n-butyl group, and X is -OH.

Next, the nanoparticles were separated from the reaction solution using a centrifuge and then dried in an oven at 60°C to prepare surface-modified SnO₂ nanoparticles (electron carrier).

### Experimental Example 1: FT-IR and TGA analysis of electron carrier

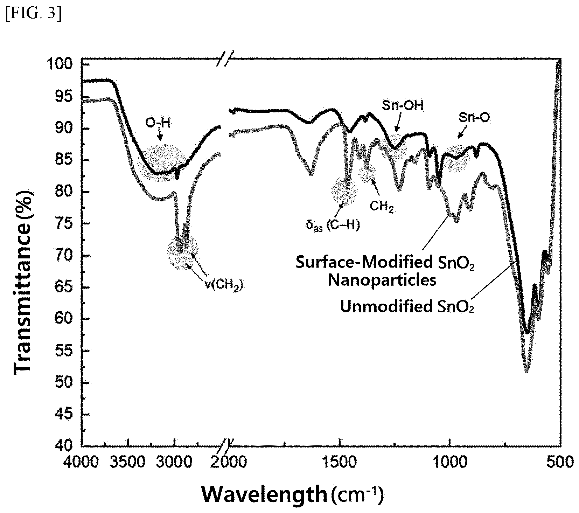

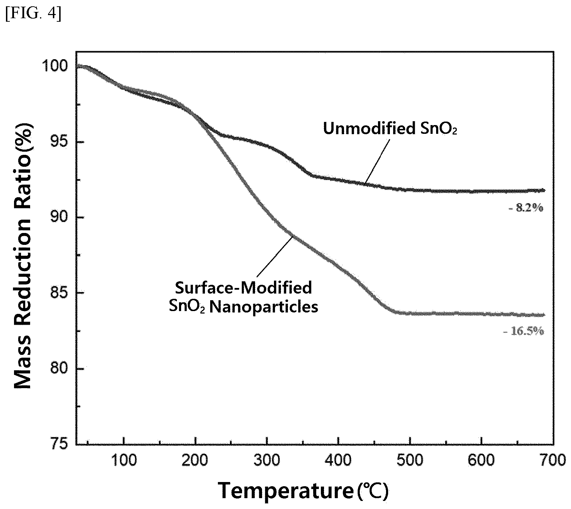

FT-IR (Fourier transform infrared spectroscopy) and TGA (thermogravimetric analysis) measurements were performed for the SnO₂ nanoparticles before and after surface modification that were prepared in Example 1-1, and the results are shown in FIGS. 3 and 4.
(1) FIG. 3 shows the FT-IR measurement results, where the black graph shows SnO₂ nanoparticles before surface modification, and the red graph shows the measurement results for surface-modified SnO₂ nanoparticles.
   Looking at FIG. 3, after surface modification, it can be confirmed that there were a v(CH2) peak at about 2,870 to 2,980 cm⁻¹, a δₐₛ(C-H) peak at about 1,460 cm⁻¹, and a CH₂ peak at about 1,380 cm⁻¹, and through this, it could be confirmed that tetrabutylphosphonium hydroxide (TBPH), which is a modifying component, existed on the surface of SnO₂ nanoparticles.
(2) In addition, FIG. 4 shows the results of TGA analysis, and when each of the SnO₂ nanoparticles before and after surface modification was heated to 700°C, in the case of unmodified SnO₂ nanoparticles (bare SnO₂) (black graph), a mass reduction of approximately 8% compared to the initial input occurred due to the removal of surface-adsorbed moisture and -OH removal. On the other hand, surface-modified SnO₂ nanoparticles (TBPH modified SnO₂) showed a rapid reduction in mass at around 200 to 350°C, and a mass reduction of about 16% occurred at 700°C.

Through this, it could be confirmed that the surface-modified SnO₂ nanoparticles included about 8% of organic matter compared to the unmodified SnO₂ nanoparticles, and it could be confirmed that the electron carrier produced through this included 92 wt% of SnO₂ nanoparticles and 8 wt% of the surface modification component.

### Comparative Example 1-1

The SnO₂ nanoparticles produced in (1) of Example 1-1 were prepared as an electron carrier without a surface modification process.

### Comparative Example 1-2

SnO₂ nanoparticles produced in (1) of Example 1-1 were prepared.

Next, 5 g of the SnO₂ nanoparticles were added to a round bottom flask containing 3 mL of ultrapure water and stirred. Then, after adding 7.5 mL of a 40 wt% aqueous solution of tetrabutylammonium hydroxide (TBAH), a reaction solution was prepared using an ultrasonicator. Next, the reaction solution was separated into nanoparticles using a centrifuge and then dried in an oven at 60°C to produce SnO₂ nanoparticles (electron carrier) that were surface-modified with TBAH.

### Comparative Example 1-3

SnO₂ nanoparticles produced in (1) of Example 1-1 were prepared.

Next, 5 g of the SnO₂ nanoparticles were added to a round bottom flask containing 3 mL of ultrapure water and stirred. Then, after adding 30 mL of a 10 wt% aqueous solution of tetramethylammonium hydroxide (TMAH), a reaction solution was prepared using an ultrasonicator. Next, the reaction solution was separated into nanoparticles using a centrifuge and then dried in an oven at 60°C to produce SnO₂ nanoparticles (electron carrier) that were surface-modified with TMAH.

### Example 2-1: Preparation of dispersion solution of electron carrier (coating solution for ETL formation)

7.0 mg of the electron carrier of Example 1-1 prepared above was added to 1.0 mL of 2,2,2-trifluoroethanol (dielectric constant = about 8.5) with low hydrophilicity. After addition, a dispersion solution-type coating solution for forming an electron transport layer was prepared using an ultrasonic grinder.

### Experimental Example 2: Measurement of dispersibility (dispersion stability) of coating liquid

The dispersibility of the coating solutions for ETL formation prepared in Example 2-1 and Comparative Examples 2-1 to 2-3 was measured by using a dynamic light scattering particle size analyzer, and the results are shown in Table 2 below. It was evaluated to have excellent dispersion stability when the Z-average average value was 20.0 nm or less, and preferably, 17.0 nm or less. The evaluation values in Table 1 are the average values of three repeated experiments. In this case, as dispersibility decreased, the particle size distribution formed multiple peaks rather than a single peak.

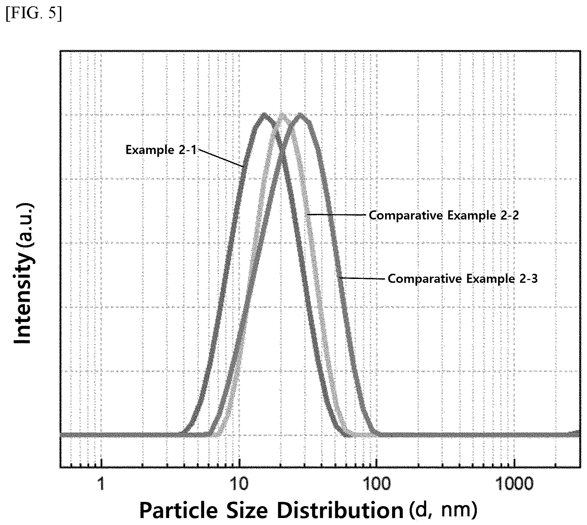

In addition, the measurement result graph of Example 2-1 (TBPH), Comparative Example 2-2 (TBAH), and Comparative Example 2-3 (TMAH) is shown in FIG. 5, and Example 2-1, Comparative Example 2-2 and Comparative Examples 2-3 all formed a single peak under the same conditions.

**[Table 1]**

| Classification | Surface-Modified SnO₂ Nanoparticles | Organic Solvent | Z-average (average, nm) |
|---|---|---|---|
| Example 2-1 | Example 1-1 (TBPH) | 2,2,2-Trifluoroethanol | 14.2 |
| Comparative Example 2-1 | Comparative Example 1-1 (control SnO₂) | | Could not be measured |
| Comparative Example 2-2 | Comparative Example 1-2(TBAH) | | 18.3 |
| Comparative Example 2-3 | Comparative Example 1-3(TMAH) | | 22.6 |

Looking at the experimental results in Table 1, in the case of a coating solution prepared with SnO₂ nanoparticles without surface modification, the dispersibility was very poor, and results could not be measured. Additionally, in the case of Comparative Example 2-2 and Comparative Example 2-3 which are coating solutions prepared by applying the nanoparticles of Comparative Example 1-2 and Comparative Example 1-3 as electron carriers, the dispersibility was excellent compared to Comparative Example 2-1, but the dispersibility tended to be relatively poor compared to Example 2-1.

### Examples 2-2 to 2-3 and Comparative Examples 2-4 to 2-5

Coating solutions for forming an electron transport layer were prepared in the same manner as in Example 2-1, except that as shown in Table 3 below, coating solutions for forming an ETL were prepared by changing the type of organic solvent used in the preparation of the coating solution, and Examples 2-2 to 2-3 and Comparative Examples 2-4 to 2-5 were performed (see Table 2).

**[Table 2]**

| Classification | Surface-modified SnO₂ Nanoparticles | Organic Solvent |
|---|---|---|
| Example 2-1 | Example 1-1 (TBPH) | 2,2,2-Trifluoroethanol |
| Example 2-2 | | Isopropyl alcohol |
| Example 2-3 | | Chlorobenzene |
| Comparative Example 2-4 | | Ethyl alcohol (dielectric constant 25) |
| Comparative Example 2-5 | | Dimethylformamide |

### Experimental Example 2: Production of ultra-thin film and measurement of surface roughness and light transmittance of coating layer

After spin coating each of the coating solutions for forming an ETL prepared in Examples 2-1 to 2-3 and Comparative Examples 2-4 to 2-5 on the perovskite thin film including a glass substrate and an upper part of the glass substrate, ultra-thin films with a thickness of 10 to 15 nm were prepared by heat treatment at 30°C.

In addition, the surface roughness of the ultra-thin film formed on the top of the perovskite thin film including the glass substrate was measured by a non-contact method and then calculated as the root-mean-square (rms) of the roughness. After measuring the surface roughness at arbitrary three points, the average value of the surface roughness of the three measured points is shown in Table 4 below.

In addition, the ultra-thin film formed on a glass substrate was measured by scanning near-infrared rays onto the substrate on which the ultra-thin film was formed using a UV spectrum measurement method to measure the absorbance and light transmittance (%) of the sample, and the results are shown in Table 3 below. In this case, the light transmittance is the light transmittance at a wavelength of 500 to 550 nm.

**[Table 3]**

| Classification | RMS (root mean square) Roughness | Light Transmittance (%) |
|---|---|---|
| Example 2-1 | 12.52 ± 1.95 nm | 91.0% |
| Example 2-2 | 15.16 ± 4.77 nm | 91.0% |
| Example 2-3 | 22.73 ± 1.66 nm | 90.9% |
| Comparative Example 2-4 | 13.35 ± 1.09 nm | 90.9% |
| Comparative Example 2-5 | Could not be measured | 90.9% |

Looking at the RMS roughness and light transmission in Table 3, it could be confirmed that Examples 2-1 and 2-2 have a very low surface roughness with an RMS roughness of 10.0 to 20.0 nm and excellent optical properties with a light transmittance of 90% or more. In the case of Comparative Example 2-4, the results showed similar surface roughness and optical properties as Examples 2-1 and 2-2. In contrast, in the case of Comparative Example 2-5, the optical properties were similar, but when forming a thin film on top of the perovskite, there was a problem in that the perovskite layer was completely melted and the roughness could not be measured.

### Manufacture Example 1: Manufacture of inverted perovskite solar cell using surface-modified SnO₂ nanoparticles

As a drain electrode (source electrode), an organic substrate (1.1 mm thick, 15.0 Ω/sq) coated with indium tin oxide (ITO) of approximately 110 nm thickness was sequentially cleaned with acetone and isopropyl alcohol (IPA) using an ultrasonic cleaner for 1 hour each.

Next, a 20 nm thick hole transport layer (NiOₓ) was formed on the ITO substrate through sputtering deposition method conditions.

Next, a yellow light absorption layer solution formed by dissolving dimethylformamide (DMF) and dimethyl sulfoxide (DMSO) was formed on the upper part of the hole transport layer through spin coating, and a NiOₓ hole-transport layer and a light absorption layer (CsMAFAPbIₓBr₃₋ₓ, 0≤x≤3) having a perovskite crystal structure with a thickness of 450 to 550 nm was formed by heat treatment at 100°C for 20 minutes.

Next, a LiF thin film of <1 nm and a passivation layer (C₆₀ fullerene) with a thickness of 13 nm were formed on the top of the light absorption layer through thermal evaporation method conditions.

Next, the coating solution for forming an ETL prepared in Example 2-1 was spin-coated on the top of the passivation layer at 4,000 rpm for 30 seconds, and then heat treated at 30°C to form an electron transport layer with a thickness of 15 nm. In this way, indium doped zinc oxide (IZO) was formed to a thickness of 100 nm as a transparent electrode layer through sputtering equipment on the top of the electroporous transport layer.

Next, silver (Ag) was deposited on the top of the electron transport layer to a thickness of 200 nm at a pressure of 1 × 10⁻⁷ torr to form a source electrode, thereby manufacturing an inverted perovskite solar cell.

### Manufacture Examples 2 to 3 and Comparative Manufacture Examples 1 to 3

Inverted perovskite solar cells were manufactured in the same manner as Manufacture Example 1, except that instead of the coating solution for forming an ETL of Example 2-1, each solar cell was manufactured by forming an electron transport layer using each of the coating solutions for forming an ETL of Examples 2-2 to 2-7 and Comparative Examples 2-2 to 2-6 to perform Manufacture Examples 2 to 3 and Comparative Manufacture Examples 1 to 3, respectively.

### Control: Solar cell with electron transport layer formed through ALD-deposition

As a control, a drain electrode, a hole transport layer, a perovskite light absorption layer and a passivation layer were formed in the same manner as in Preparation Example 1, and then, a SnOₓ deposition layer (electron transport layer) with a thickness of 6 nm was formed on top of the passivation layer by atomic layer deposition.

Next, silver (Ag) was deposited on the top of the electron transport layer to a thickness of 150 nm at a pressure of 1 × 10⁻⁸ torr to form a source electrode, thereby manufacturing an inverted perovskite solar cell.

### Experimental Example 2: Performance measurement of translucent solar cells

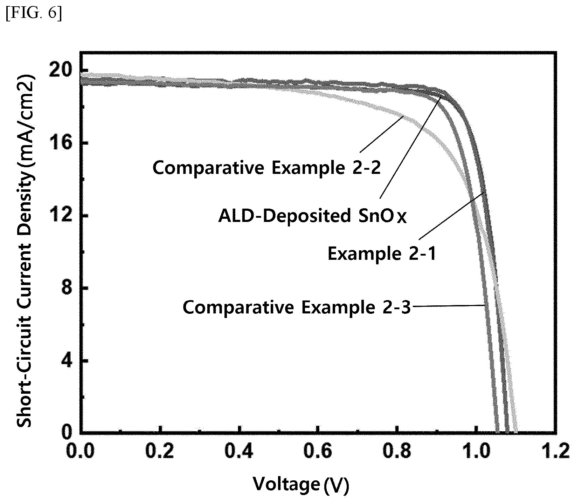

The current-voltage characteristics and efficiency of the translucent solar cell manufactured in Manufacture Example 1 were measured, and the results are shown in Table 4 below. In addition, the short-circuit current density and photoelectric conversion efficiency (PCE) measurement results for Manufacture Example 1 and the control are shown in FIG. 6.

**[Table 4]**

| Classification | Electron Transport Layer | Open-circuit Voltage (V_{oc}, V) | Short-circuit Current Density (J_{sc}, mA/cm²) | Fill Factor (FF) | Photovoltaic Conversion Efficiency (%) |
|---|---|---|---|---|---|
| Control | ALD deposition | 1.078 | 19.32 | 82.19 | 17.12 |
| Manufacture Example 1 | Example 2-1 (TBPH-TFE) | 1.078 | 19.52 | 82.10 | 17.28 |
| Manufacture Example 2 | Example 2-2 (TBPH-IPA) | 1.039 | 20.36 | 68.78 | 14.56 |
| Manufacture Example 3 | Example 2-3(TBPH-CB) | 1.031 | 17.99 | 58.55 | 10.86 |
| Comparative Manufacture Example 1 | Comparative Example 2-1 (control SnO₂) | Could not be measured | Could not be measured | Could not be measured | Could not be measured |
| Comparative Manufacture Example 2 | Comparative Example 2-2 (TBAH) | 1.100 | 19.80 | 67.08 | 14.61 |
| Comparative Manufacture Example 3 | Comparative Example 2-3 (TMAH) | 1.054 | 19.38 | 80.51 | 16.43 |
| Comparative Manufacture Example 4 | Comparative Example 2-4 (TBPH-EtOH) | 0.827 | 15.21 | 46.81 | 5.88 |
| Comparative Manufacture Example 5 | Comparative Example 2-5 (TBPH-DMF) | Could not be measured | Could not be measured | Could not be measured | Could not be measured |

Looking at the solar cell performance measurement results in Table 4 above, in the case of Manufacture Example 1, it showed similar solar cell performance (current-voltage characteristics, fill factor, photovoltaic conversion efficiency) to the solar cell composed of ETL formed by ALD deposition. In contrast, in the case of Comparative Manufacture Example 1 in which ETL was formed by a coating solution in which SnO₂ nanoparticles (Comparative Example 2-2) that were surface-modified with TBAH were introduced as an electron transport material., there was a problem in that the fill factor decreased compared to Manufacture Example 1. This was because TBAH, which is a surface modification component of the electron carrier, reacted with the fullerene material (C₆₀) of the passivation layer, thereby damaging the passivation layer and deteriorating solar cell performance.

On the other hand, the solar cell of Comparative Manufacture Example 2 showed no damage to the passivation layer, but showed somewhat lower performance compared to Manufacture Example 1, and it can be inferred that this was a result of the decrease in film density and uniformity due to the lower dispersibility compared to the dispersion solution used in Manufacture Example 1.

Additionally, in the case of Comparative Manufacture Example 2 in which the ETL was formed by a coating solution (Example 2-2) using isopropyl alcohol as an organic solvent in the coating solution for forming an ETL and Comparative Manufacture Example 3 in which the ETL was formed by a coating solution (Example 2-3) using chlorobenzene as an organic solvent, the results showed poor solar cell performance, which appears to be due to reduced film uniformity caused by the relatively low dispersibility of the electron carrier in the coating solution for forming an ETL.

Additionally, in the case of Comparative Preparation Example 4 in which ETL was formed by a coating solution using ethanol (EtOH) as an organic solvent, the perovskite photoactive layer was damaged by ethanol, which is an organic solvent, and it could be confirmed that the performance of the solar cell device deteriorated.

### Manufacture Example 4: Manufacture of tandem perovskite solar cell to which surface-modified SnO₂ nanoparticles are applied

A PERC structure cell was used as a lower solar cell.

The PERC structure cell is manufactured by Hanwha Q CELLS by forming an n⁺⁺ emitter layer through the POCl process on a p-type impurity-doped silicon substrate on which a lower passivation layer and lower electrode are formed.

Next, an indium tin oxide (ITO) layer was formed to a thickness of 50 nm as a recombination layer on top of the n⁺⁺ emitter layer using sputtering equipment.

Next, a 20 nm thick hole transport layer (NiOₓ) was formed on the ITO substrate through sputtering deposition method conditions.

Next, a yellow light absorption layer solution formed by dissolving dimethylformamide (DMF) and dimethyl sulfoxide (DMSO) was formed on the top of the hole transport layer through spin coating, by heat treating at 100°C for 20 minutes, a NiOₓ hole transport layer and a light absorption layer (CsMAFAPbIₓBr₃₋ₓ (0≤x≤3)) having a perovskite crystal structure with a thickness of 450 to 550 nm were formed.

Next, a LiF thin film le that was than 1 nm thick and a passivation layer (C60 fullerene) with a thickness of 13 nm were formed on the top of the light absorption layer through thermal evaporation method conditions.

Next, the coating solution for forming an ETL prepared in Example 2-1 was spin-coated on the top of the passivation layer at 4,000 rpm for 30 seconds, and then heat treated at 30°C to form an electron transport layer with a thickness of 15 nm. Next, indium-doped zinc oxide (IZO) or tin-doped indium oxide (ITO) was formed to a thickness of 100 nm as a transparent electrode layer through sputtering equipment on the top of the electroporation layer.

Next, a tandem perovskite solar cell was manufactured by depositing silver (Ag) on the top of the electron transport layer to a thickness of 200 nm at a pressure of 1 × 10⁻⁷ torr to form a source electrode.

### (2) Manufacture of control (ALD deposition)

As a control, a tandem perovskite solar cell was manufactured in the same manner as in Preparation Example 4, except that after forming the same hole transport layer, perovskite light absorption layer and passivation layer as in Manufacture Example 4 on the n⁺⁺ emitter layer of the PERC structure cell, which is a lower solar cell, a SnOₓ deposition layer (electron transport layer) with a thickness of 6 nm was formed on the passivation layer by atomic layer deposition..

Next, a tandem perovskite solar cell was manufactured by depositing silver (Ag) on the top of the electron transport layer to a thickness of 150 nm at a pressure of 1 × 10⁻⁸ torr to form a source electrode.

### Comparative Manufacture Examples 6 and 7

Tandem perovskite solar cells were manufactured in the same manner as Manufacture Example 4, except that the coating solutions for forming an ETL of Comparative Examples 2-2 and 2-3 were used instead of the coating solution for forming an ELT of Example 2-1 such that each tandem solar cell in which the electron transport layer was formed was manufactured to perform Comparative Manufacture Examples 6 and 7, respectively (see Table 5 below).

### Experimental Example 3: Performance measurement of silicon-perovskite tandem solar cells

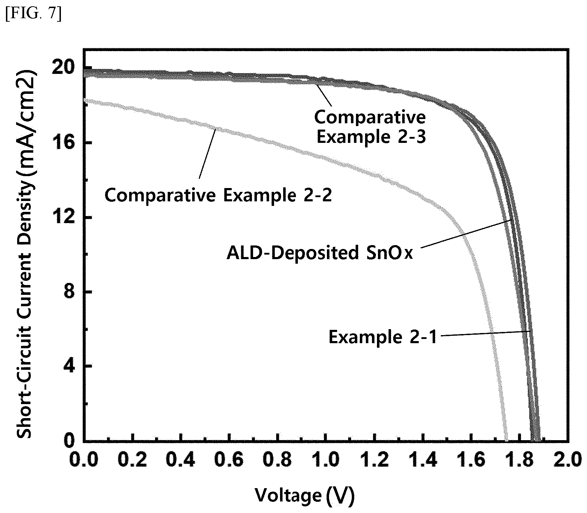

The current-voltage characteristics and efficiency of the silicon-perovskite tandem solar cells manufactured in Manufacture Example 4, the control and Comparative Manufacture Examples 6 to 7 were measured, and the results are shown in Table 5 below. In addition, the short-circuit current density and photoelectric conversion efficiency (PCE) measurement results for Manufacture Example 4 and the control are shown in FIG. 7.

**[Table 5]**

| Classification | Electron Transport Layer | Open-circuit Voltage (V_{oc}, V) | Short-circuit Current Density (J_{sc}, mA/cm²) | Fill Factor (FF) | Photovoltaic Conversion Efficiency (%) |
|---|---|---|---|---|---|
| Control | ALD deposition | 1.851 | 19.86 | 74.75 | 27.48 |
| Manufacture Example 4 | Example 2-1 (TBPH-TFE) | 1.878 | 19.72 | 75.35 | 27.91 |
| Comparative Manufacture Example 6 | Comparative Example 2-2 (TBAH) | 1.745 | 18.28 | 57.70 | 18.41 |
| Comparative Manufacture Example 7 | Comparative Example 2-3 (TMAH) | 1.883 | 19.66 | 74.66 | 27.63 |

Looking at the tandem solar cell device performance measurement results shown in Table 5 and FIG. 7, it was confirmed that the tandem solar cell device of Manufacture Example 1 had an excellent photoelectric conversion efficiency.

## Claims

1. An electron carrier for an electron transport layer of a perovskite solar cell, comprising metal oxide nanoparticles that are surface-modified with a phosphonium salt represented by Chemical Formula 1 below: 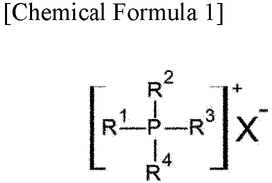 wherein in Chemical Formula 1, each of R¹ to R⁴ is independently a C₁ to C₁₀ straight-chain alkyl group, a C₃ to C₁₀ branched alkyl group, a phenyl group or a benzyl group, and X is a halogen atom or -OH.

2. The electron carrier of claim 1, wherein the metal oxide nanoparticles comprise an oxide of a metal comprising at least one or two selected from tin (Sn), zirconium (Zr), strontium (Sr), zinc (Zn), vanadium (V), molybdenum (Mo), tungsten (W), niobium (Nb), aluminum (Al) and gallium (Ga).

3. The electron carrier of claim 1 or 2, wherein the electron carrier comprises 85.0 to 95.0 wt% of the metal oxide nanoparticles and the remaining amount of a surface modification component based on the total weight of the electron carrier.

4. The electron carrier of claim 1, wherein the metal oxide nanoparticles have a particle size of 1 to 100 nm.

5. A coating agent for an electron transport layer of a perovskite solar cell, comprising an organic solvent and the electron carrier according to any one of claims 1 to 4,
wherein the organic solvent has a dielectric constant of 20 or less.

6. The coating agent of claim 5, wherein the coating agent comprises 0.30 to 2.00 wt% of the electron carrier and the remainder of the organic solvent.

7. Th coating agent of claim 5, wherein the organic solvent comprises at least one selected from isopropyl alcohol, butyl alcohol, 2,2,2-trifluoroethanol, chlorobenzene and chloroform.

8. An electron transport layer of a perovskite solar cell, comprising a coating layer formed by the coating agent of claim 5.

9. The electron transport layer of claim 8, wherein the electron transport layer has a thickness of 10 to 200 nm, and
wherein when the electron transport layer has a thickness of 10 to 15 nm, the electron transport layer has a light transmittance of 88.0% or more for a wavelength of 500 to 550 nm.

10. A perovskite solar cell, wherein the electron transport layer of claim 8 is directly formed on an upper surface of a perovskite light absorption layer, or
wherein a passivation layer is formed between a perovskite light absorption layer and the electron transport layer of claim 8.

11. The perovskite solar cell of claim 10, wherein the passivation layer comprises at least one selected from C₆₀ fullerene, C₇₀ fullerene, C₇₂ fullerene, C₇₆ fullerene and C₈₄ fullerene.
